Europäisches Patentamt

European Patent Office

Office européen des brevets

(11) Veröffentlichungsnummer: **0 316 476**
**A1**

## (12) EUROPÄISCHE PATENTANMELDUNG

(21) Anmeldenummer: 87117048.6

(22) Anmeldetag: 19.11.87

(51) Int. Cl.⁴: **A01K 97/12**

(43) Veröffentlichungstag der Anmeldung:
24.05.89 Patentblatt 89/21

(84) Benannte Vertragsstaaten:
**AT BE CH DE ES FR GB GR IT LI LU NL SE**

(71) Anmelder: **Happ, Catherine**
**Nürnberger Strasse 145**
**D-8600 Bamberg(DE)**

(72) Erfinder: **Happ, Dieter**
**Theodor-Heuss-Ring 26**
**D-8600 Bamberg(DE)**
Erfinder: **Wehrl, Peter**
**Ringstrasse 106**
**D-8608 Memmelsdorf(DE)**

(74) Vertreter: **Göbel, Matthias, Dipl.-Ing.**
**Pruppacher Hauptstrasse 5-7**
**D-8501 Pyrbaum-Pruppach(DE)**

(54) Vorrichtung zum Angeln von Fischen.

(57) Bei einer Vorrichtung zum Angeln von Fischen
mit einer an einer Angelrute längsgeführten Angelleine und einem durch die Angelleine betätigbarem
Geber für eine das Anbeißen der Fische anzeigenden elektrischenSignaleinrichtung ist zur Bildung einer empfindlich arbeitenden Signaleinrichtung der
Geber (8) durch einen in Abhängigkeit von den
Längsbewegungen der Angelleine (3') magnetisch
betätigbaren Schalter (22) gebildet.

Fig.2

EP 0 316 476 A1

## Vorrichtung zum Angeln von Fischen

Die Erfindung betrifft eine Vorrichtung zum Angeln von Fischen mit einer an einer Angelrute längsgeführten Angelleine und einem durch die Angelleine betätigbaren Geber für eine das Anbeißen der Fische anzeigenden elektrischen Signaleinrichtung.

Bei einer bekannten Angelvorrichtung mit Signaleinrichtung zum Erkennen des Anbeißens von Fischen ist die Angelleine durch eine als Geber dienende Lichtschranke hindurchgeführt, die mit einer Auswerteeinrichtung in Verbindung steht. Diese Signaleinrichtung arbeitet jedoch relativ unempfindlich und erfordert außerdem einen hohen Strombedarf. Bei einer weiterhin bekannten Angelvorrichtung mit Signaleinrichtung ist die Angelleine über Magnetkontakte eines Reedrelais geführt und die Schaltungen desselben werden in einer Auswerteeinrichtung erkannt. Abgesehen davon, daß diese Vorrichtung ebenfalls nur unempfindlich arbeitet, ist sie auch mit einem großen baulichen Aufwand behaftet.

Es ist Aufgabe der Erfindung eine empfindlich arbeitende Signaleinrichtung mit einfachem Aufbau für eine Angelvorrichtung zu schaffen.

Erfindungsgemäß ist diese Aufgabe dadurch gelöst, daß der Geber durch einen in Abhängigkeit von den Längsbe wegungen der Angelleine magnetisch betätigbaren Schalter gebildet ist. Die Angelleine ist dabei einfach über eine Antriebsrolle für eine drehbar verbundene Indikatorrolle führbar, der ein mit einer elektronischen Auswertezentrale verbundener Siliziummagnetfeldschalter zugeordnet ist. Bevorzugt kann die Indikatorrolle durch einen zylindrischen Formkörper aus einem magnetisch indifferenten Werkstoff und einem auf der Umfangsfläche des Formkörpers fest aufgebrachten Folienband mit einer Anzahl quer im Abstand nebeneinander angeordneten Leistenkörpern aus magnetischen Werkstoff gebildet sein. Bei der so erzielten Signalvorrichtung führen die Drehbewegungen von Antriebs- und Indikatorrolle zu Ansprechbewegungen des Siliziummagnetfeldschalters und über die Auswerteeinrichtung zu optischen und/oder akustischen Signalen für den Benutzer. Der Siliziummagnetfeldschalter gibt bei kleinstem Raumbedarf die Voraussetzungen zu einem empfindlichen Arbeiten der Signaleinrichtung, wobei bereits Teilbewegungen der Indikatorrolle zu Signalabgaben führen. Außerdem wird nur ein geringer Strombedarf gefordert.

In Ausgestaltung der Vorrichtung ist vorgesehen, daß die Antriebsrolle, die Indikatorrolle und der Siliziummagnetfeldschalter in einem gemeinsamen Gebergehäuse untergebracht sind, daß auf einem, z. B. stabförmigen Träger ortsveränderlich fixierbar ist. Zweckmäßig ist das Gebergehäuse an seinem oberen Ende mit einer keilförmigen Ausnehmung mit Stützflächen für die Angelrute versehen. Bevorzugt schließt sich an dieser Ausnehmung nach unten eine weitere Ausnehmung für die Durchführung der Antriebsrolle an. Das Gebergehäuse führt so zu ei nem Doppeleffekt, dahingehend, daß es als Stütze für die Angelrute dient und die Aufnahme für den Geber bildet.

Weiter ist vorgesehen, daß das Gebergehäuse und die Auswertezentrale der Signaleinrichtung im Abstand nebeneinander auf dem stabförmigen Träger ausgebildet sind und daß das Gebergehäuse und die Auswertezentrale durch flexible elektrische Leiter miteinander verbunden sind. Es versteht sich, daß der Träger eine beliebige Anzahl Geber haltern kann. So ist möglich einer Auswertezentrale mehrere der Geber zuzuordnen, die so als Stützen für eine entsprechende Anzahl Angelruten zum Einsatz bringbar sind und auf eine einzige Auswertezentrale zur Erzeugung von unabhängigen Signalen wirken.

Eine vorteilhafte Ausgestaltung für die Auswertezentrale ist dann erzielbar, wenn die elektronische Einrichtung derselben auf einem die elektronischen Bauelemente tragenden Modul angeordnet sind. Zweckmäßig ist die Auswertezentrale für die austauschbare Aufnahme einer Anzahl Module vorgesehen.

Um auch bei schwachen Lichtverhältnissen, z. B. während der Dunkelheit optische Anzeigen deutlich zu machen, ist vorgesehen, die Betätigungen des Gebers durch eine am Gebergehäuse angeordnete Leuchtanzeige sichtbar zu machen. Als Leuchtanzeige sind, z. B. Leuchtdioden oder Glühlampen verwendbar. Zweckmäßig ist die Leuchtanzeige farbig ausgebildet. Als besonders vorteilhaft hat sich schließlich erwiesen, wenn der Geber und die Auswerte zentrale optische und/oder akustische Anzeigen mit regelbarer Intensität aufweisen. Für den Benutzer besteht so die Möglichkeit, die Anzeigen den Lichtverhältnissen bzw. Entfernungen anzupassen.

Es entspricht dem Erfindungsgedanken, daß die Signaleinrichtung gleichermaßen mit einer internen oder externen Stromquelle betrieben werden kann. Als interne Stromquelle ist eine Batterie oder Akkumulator denkbar. Die Erfindung ist anhand eines Ausführungsbeispiels in der Zeichnung verdeutlicht. Hierin bedeuten:

Fig. 1 eine Angeleinrichtung mit Signaleinrichtung in Seitenansicht,

Fig. 2 ein Teilstück einer Signaleinrichtung, vergrößert,

Fig. 3 einen Teilschnitt eines Gebers und

Fig. 4 ein Teilstück einer Indikatorrolle mit Siliziummagnetfeldschalter.

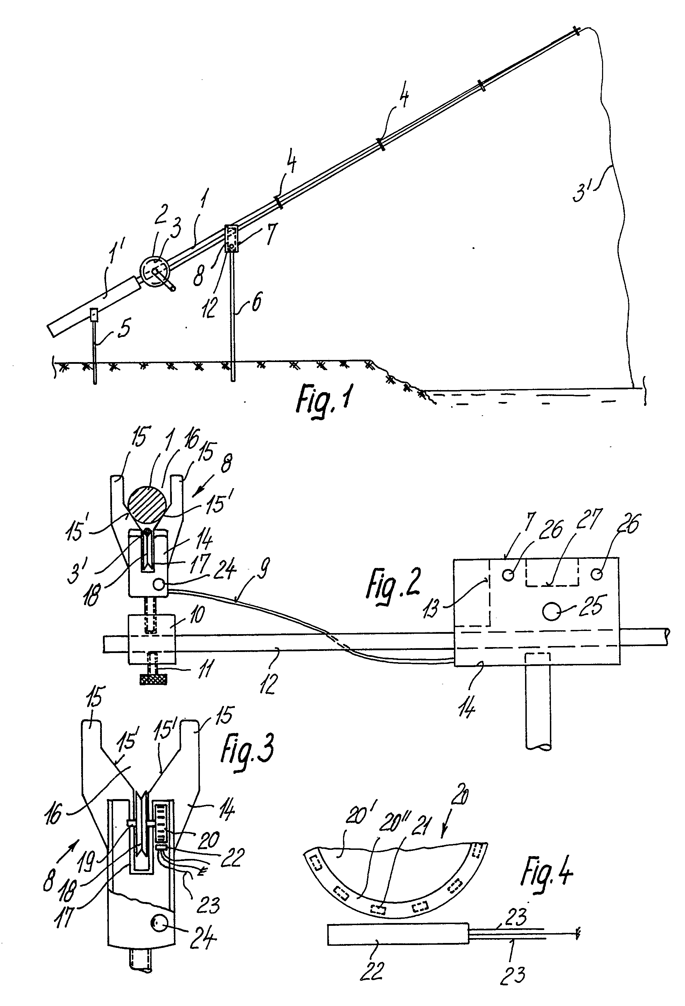

In Fig. 1 ist mit 1 eine an sich bekannte Angelrute bezeichnet, die eine Winde 2 für die Aufnahme eines Angelleinenwickels 3 und Führungsringe 4 für die Angelleine 3' aufweist. Die Angelrute 1 ist beim Ausführungsbeispiel mit ihrem Griffteil 1' auf eine Bodenstütze 5 aufgelegt. Auf einem weiteren stabförmigen Träger 6 ist eine Auswertezentrale 7 aufgesetzt, die mit einem oder mehreren Gebern 8 über elektrische Leiter 9 in Verbindung steht. Der Geber 8 ist durch einen Schieber 10 getragen, der mittels eines Klemmmittels 11 mit mehr oder weniger großem Abstand von der Auswertezentrale auf einer Querstütze 12 feststellbar ist. Die Auswertezentrale 7 ist mit einer internen Stromquelle 13, z.B. eine Batterie oder Akku ausgerüstet. Außerdem nimmt die Auswertezentrale zu einem Modul zusammengefaßte elektronische Bauteile (nicht gezeigt) auf. Mit 26 sind optische Anzeigen, z.B. Leuchtdioden und mit 27 eine akustische Anzeige bezeichnet, während 25 ein Betätiknopf für Intensitätsveränderungen ist.

Der Geber 8 weist ein Aufnahmegehäuse 14 auf, das an seinem oberen Ende nach außen abstehende Anformungen 15 aufweist. Die einander zugewandten Begrenzungsflächen 15' der Anformungen 15 bilden Stützflächen für die Angelrute 1, die auf diese Weise, wie in Fig. 1 gezeigt, eine zusätzliche Abstützung erhält. Mit der Ausnehmung 16 ist eine weitere Ausnehmung 17 in Verbindung gebracht, in die eine Antriebsrolle 18 frei drehbar ist. Über die Antriebsrolle 18 ist die Angelleine 3' hinweggeführt, so daß bei Längsbewegungen der Angelleine 3' selbsttätig Drehbewegungen der Antriebsrolle 18 erfolgen. Mit der Welle 19 der Antriebsrolle 18 ist eine Indikatorrolle 20 drehfest verbunden. Die Indikatorrolle trägt auf einem Rollenkörper 20' aus einem magnetisch indifferenten Werkstoff außen einen Folienstreifen 20" mit einer Anzahl magnetisch wirksamer Stabkörper 21. Bei Drehbewegungen der Antriebswelle 18 wird die Indikatorrolle 20 synchron mitgedreht. Der Indikatorrolle 20 ist ein Siliziummagnetfeldschalter 22 zugeordnet, der über elektrische Leiter 23 mit der Auswertezentrale 7 verbunden ist.

Wird davon ausgegangen, daß vor dem Anbeißen eines Fisches die Angelleine 3' unverschieblich an der Angelrute 1 geführt ist. Hierbei verbleiben die Antriebsrolle 18 und die Indikatorrolle 20 in Ruhe.

Bei einem Anbeißen eines Fisches und den dadurch an der Angelleine 3' bedingten Zugeinwirkungen führt diese eine Längsbewegung aus, die zu Drehungen von Antriebsrolle 18 und Indikatorrolle 20 und Ansprechen des Siliziummagnetfeldschalter führt, der einen Impuls an die Auswertezentrale 7 gibt. Für den Benutzer ist nunmehr eine optische und/oder akustische Anzeige wahrnehmbar. Zum besseren Erkennen der Anzeigen, etwa in der Dunkelheit, kann auch das Gehäuse des Gebers 8 eine zusätzliche optische Anzeige 24 aufweisen.

Es versteht sich, daß einer Auswertezentrale 7 eine beliebige Anzahl Geber zugeordnet sein können. Bevorzugt sind die elektronischen Bauelemente der Geber auf Modulen angeordnet, so daß durch Einfügen mehrerer Module eine Umrüstung der Auswertezentrale einfach möglich ist.

## Ansprüche

1. Vorrichtung zum Angeln von Fischen mit einer an einer Angelrute längsgeführten Angelleine und einem durch die Angelleine betätigbarem Geber für eine das Anbeißen der Fische anzeigenden elektrischen Signaleinrichtung, dadurch gekennzeichnet, daß der Geber (8) durch einen in Abhängigkeit von den Längsbewegungen der Angelleine (3') magnetisch betätigbaren Schalter (22) gebildet ist.

2. Vorrichtung nach Anspruch 1, dadurch gekennzeichnet, daß die Angelleine (3') über eine Antriebsrolle (18) für eine drehbar verbundene Indikatorrolle (20) geführt ist und daß der Indikatorrolle (20) ein mit einer elektronischen Auswertezentrale (7) verbundener Siliziummagnetfeldschalter (22) zugeordnet ist.

3. Vorrichtung nach Anspruch 1 und 2, dadurch gekennzeichnet, daß die Indikatorrolle (20) durch einen zylindrischen Formkörper (20') aus einem magnetisch indifferenten Werkstoff und einem auf der Umfangsfläche des Formkörpers (20') fest aufgebrachten Folienband (20") mit einer Anzahl quer im Abstand nebeneinander angeordneten Leistenkörpern (21) aus magnetischem Werkstoff gebildet ist.

4. Vorrichtung nach Anspruch 2, dadurch gekennzeichnet, daß die Antriebsrolle (18),die Indikatorrolle (20) und der Siliziummagnetfeldschalter (22) in einem gemeinsamen Gebergehäuse (14) untergebracht sind, das auf einem stabförmigen Träger (12) ortsveränderlich fixierbar ist.

5. Vorrichtung nach Anspruch 4, dadurch gekennzeichnet, daß das Gebergehäuse (14) am oberen Ende eine keilförmige Ausnehmung (16) mit Stützflächen (15') für die Angelrute (1) aufweist, an die sich nach unten eine Ausnehmung (17) für die Durchführung der Antriebsrolle (18) anschließt.

6. Vorrichtung nach Anspruch 4, dadurch gekennzeichnet, daß der stabförmige Träger (6, 12), das Gebergehäuse (14) und die Auswertezentrale (7) der Signaleinrichtung im Abstand trägt und daß das Gebergehäuse (14) und die Auswertezentrale (7) durch flexible elektrische Leiter miteinander verbunden sind.

7. Vorrichtung nach Anspruch 6, dadurch gekennzeichnet, daß der stabförmige Träger (6, 12) mindestens einen Geber (8) aufnimmt und daß die Auswertezentrale (7) der Anzahl der Geber (8) entsprechende Anzahl optischer und/oder akustischer Anzeigen (26, 27) aufweist.

8. Vorrichtung nach Anspruch 2 und 4, dadurch gekennzeichnet, daß Betätigungen des Gebers (8) durch eine im Gebergehäuse (14) angeordnete Leuchtanzeige (24) sichtbar sind.

9. Vorrichtung nach Anspruch 1, 4 und 5, dadurch gekennzeichnet, daß das Gebergehäuse (14) und die Auswertezentrale (7) Anzeigen(24, 26, 27) mit einregelbarer Intensität aufweisen.

10. Vorrichtung nach Anspruch 2, dadurch gekennzeichnet, daß die Auswertezentrale (7) eine interne Stromquelle (13) aufweist.

11. Vorrichtung nach Anspruch 1, dadurch gekennzeichnet, daß die elektronische Einrichtung der Auswertezentrale (7) auf einem die elektronischen Bauelemente tragenden Modul angeordnet sind.

12. Vorrichtung nach Anspruch 11, dadurch gekennzeichnet, daß die Auswertezentrale (7) eine Anzahl Module austauschbar aufnimmt.

Fig. 1

Fig. 2

Fig. 3

Fig. 4

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | GB-A-1 503 596 (DELLAREED LTD) * Insgesamt * | 1 | A 01 K 97/12 |
| A | | 2-8,10-12 | |
| A | IEEE ELECTRO, Band 7, Mai 1982, Seiten 1-12(19/2), New York, US; R.W. NELSON: "Integrated hall sensors" * Seiten 1-9 * | 2,3 | |
| X | GB-A-2 025 741 (NICHOLSON) * Insgesamt * | 1-3,7,8 | |
| X | GB-A-2 149 631 (I & C CARBONITE LTD) * Insgesamt * | 1,2,4,8 -11 | |

RECHERCHIERTE SACHGEBIETE (Int. Cl.4)

A 01 K
H 03 K

Der vorliegende Recherchenbericht wurde für alle Patentansprüche erstellt

| Recherchenort | Abschlußdatum der Recherche | Prüfer |
|---|---|---|
| DEN HAAG | 18-04-1988 | VERDOODT S.J.M. |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes
    Dokument

EPO FORM 1503 03.82 (P0403)